# EUROPEAN PATENT APPLICATION

(11) **EP 4 534 821 A1**
(43) Date of publication of application: **09.04.2025**
(21) Application number: 24203852.9
(22) Date of filing: 01.10.2024
(51) Int. Cl.: F02C 3/22, F02D 29/06, F02D 19/02

(54) **WASTE HYDROGEN POWER GENERATION DEVICE**

(30) Priority: 02.10.2023 JP 2023171582
(71) Applicant: Epicrew Corporation, Ohmura-shi, Nagasaki 856-0022 (JP); I Labo Corporation, Tokyo 1040061 (JP)
(72) Inventor: OKABE, Akira, Nagasaki, 8560022 (JP); YAMAOKA, Tomonori, Nagasaki, 8560022 (JP); OHTA, Nobuhiro, Tokyo, 1040061 (JP); OZAWA, Mamoru, Tokyo, 1040061 (JP)
(74) Representative: AWA Sweden AB

(57) **Abstract**

A waste hydrogen power generation device (1A; 1B) is characterized by including a hydrogen generator (10); a purification unit (20) that collects waste hydrogen discarded from the hydrogen generator (10) and removes impurities other than hydrogen to prepare purified hydrogen; a storage unit (30) that stores the purified hydrogen; and a power generation unit (40) that operates a power generator (41) by combusting the purified hydrogen supplied from the storage unit (30) and oxygen in an atmosphere.

## Description

### BACKGROUND OF THE INVENTION

### 1. Field of the Invention

The present invention relates to a waste hydrogen power generation device. More specifically, the present invention relates to a device that recovers hydrogen discharged in the semiconductor manufacturing process to generate electricity.

### 2. Description of Related Art

Semiconductor manufacturing includes multiple complex and precisely controlled stages. Accordingly, each process requires a large amount of electricity. Therefore, effective utilization of energy and resources, for example, which have been previously only emitted and not reused or utilized in semiconductor manufacturing facilities, has been considered.

For example, power generation using waste heat generated during the operation of the semiconductor manufacturing device has been proposed (see Japanese Laid-Open Patent Publication No. 2020-150045 and WO2013/047320, for example). According to these proposed technologies, they have achieved a certain level of effectiveness in the utilization of waste heat. However, it has been found that in semiconductor manufacturing processes such as by epitaxial growth devices, gaseous components such as hydrogen are generated from gases introduced for epitaxial growth in addition to waste heat.

Currently, hydrogen is highly flammable, and thus its concentration is diluted to a safe level and released outside the manufacturing facility building (into the atmosphere) for disposal. Accordingly, the use of discarded hydrogen as fuel for fuel cells has been proposed as an effective usage of hydrogen. However, fuel cells must use extremely pure hydrogen. For example, the gases from the epitaxial growth device contain components other than hydrogen. Therefore, it is not easy to remove impurities and increase the purity of hydrogen, which in turn increases the costs load for hydrogen purification.

### SUMMARY OF THE INVENTION

The present invention has been provided in view of the above mentioned points, and provides a waste hydrogen power generation device that is capable of reusing hydrogen discarded at manufacturing facilities of semiconductors, for example, to generate power with less load of purification, and assisting in supplying electricity to facilities.

A waste hydrogen power generation device is characterized by including a hydrogen generator; a purification unit that collects waste hydrogen discarded from the hydrogen generator and removes impurities other than hydrogen to prepare purified hydrogen; a storage unit that stores the purified hydrogen; and a power generation unit that operates a power generator by combusting the purified hydrogen supplied from the storage unit and oxygen in an atmosphere.

Further, in the waste hydrogen power generation device, the hydrogen generator may be an epitaxial growth device.

Moreover, in the purification unit of the waste hydrogen power generation device, the impurities of the waste hydrogen may be removed through contact with water.

Furthermore, in the waste hydrogen power generation device, the power generation unit may include a gas turbine unit that rotates by combustion of the purified hydrogen and oxygen in an atmosphere, and rotational force generated in the gas turbine unit may move the power generator.

Further, in the waste hydrogen power generation system, the power generation unit may include an internal combustion engine unit that combusts the purified hydrogen and oxygen in an atmosphere to obtain rotational force, and the rotational force generated in the internal combustion engine unit may move the power generator.

Moreover, the waste hydrogen power generation device may further include a power storage unit that stores the power generated in the power generation unit of the waste hydrogen power generation device.

Furthermore, in the waste hydrogen power generation device, the purification unit, storage unit, and power generation unit may be housed in a single enclosure.

The waste hydrogen power generation device according to the present invention includes: a hydrogen generator; a purification unit that collects waste hydrogen discarded from the hydrogen generator and removes impurities other than hydrogen to prepare purified hydrogen; a storage unit that stores the purified hydrogen; and a power generation unit that operates a power generator by combusting the purified hydrogen supplied from the storage unit and oxygen in an atmosphere, thereby, for example, reducing the load of purifying hydrogen discarded at manufacturing facilities for semiconductors, for example, reusing it for power generation, assisting in the supply of electricity to the facilities, and reducing the amount of usage of electricity.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is a schematic diagram illustrating an overall configuration of a waste hydrogen power generation device according to a first embodiment,
FIG. 2 is a first schematic diagram illustrating a power generation unit,
FIG. 3 is a second schematic diagram illustrating the power generation unit, and
FIG. 4 is a schematic diagram illustrating an overall configuration of a waste hydrogen power generation device according to a second embodiment.

### DETAILED DESCRIPTION OF EMBODIMENTS

The waste hydrogen power generation device according to an embodiment is directed to a device that collects hydrogen discarded (discharged) from an epitaxial growth device, for example, mainly in the semiconductor manufacturing process, and operates a power generator by combusting the hydrogen. Especially, fuel cells that use discarded hydrogen as fuel are not used. Hydrogen as the fuel for fuel cells must be purified to a high purity of 99% or higher, otherwise a device for the fuel cells will malfunction and efficiency will be reduced. This increases the load in terms of facilities and time needed to purify the discarded hydrogen. Therefore, the waste hydrogen power generation device according to the present embodiment applies a power generation device found in the field of hydrocarbon fuels as a method of obtaining power other than fuel cells.

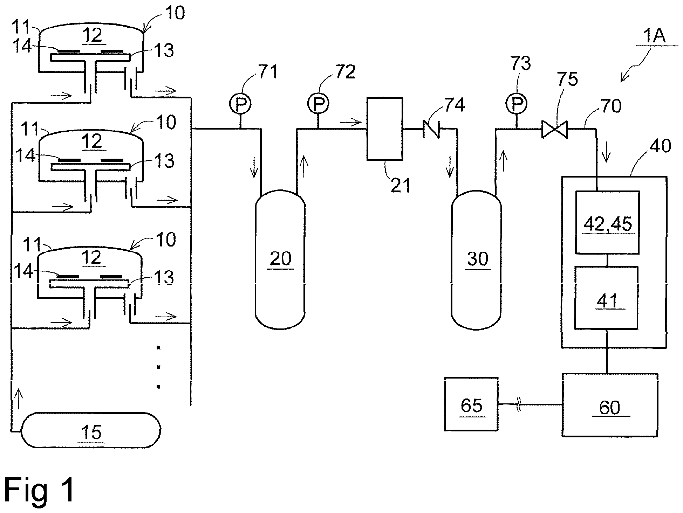

FIG. 1 is a schematic diagram illustrating an overall configuration of a waste hydrogen power generation device 1A according to the first embodiment. The waste hydrogen power generation device 1A includes hydrogen generators 10, a purification unit 20, a storage unit 30, and a power generation unit 40. The waste hydrogen power generation device 1A further includes a power storage unit 60. A waste hydrogen power generation device 1B described below also includes hydrogen generators 10, a purification unit 20, a storage unit 30, a power generation unit 40 (power generator 41), and a power storage unit 60 as well.

The power storage unit 60 is connected to a power consumption unit 65 such as lighting and pumps in manufacturing facilities and equipment. Pressure gauges 71, 72, 73, a check valve 74, a flow control valve 75, and other flow meters (not shown) are provided at various locations in a gas transfer piping 70. They monitor the pressure and flow rate of the appropriate transferred gas (waste hydrogen and purified hydrogen).

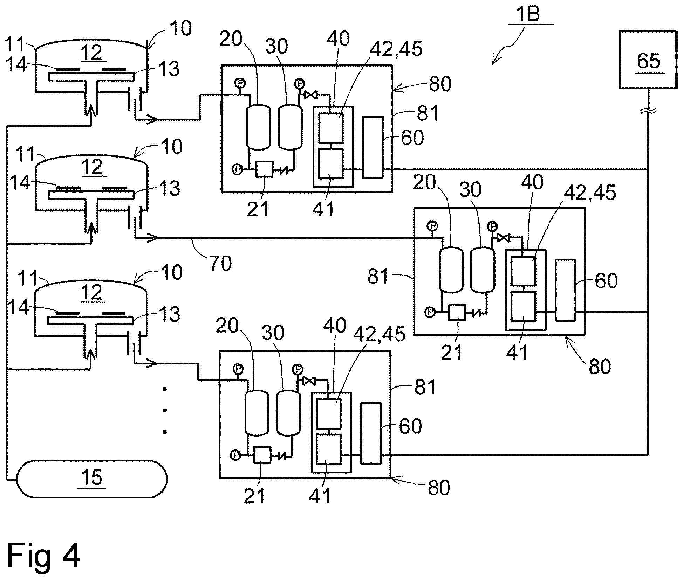

The waste hydrogen power generation device 1A according to the first embodiment and the waste hydrogen power generation device 1B according to the second embodiment (see FIG. 4) use epitaxial growth devices 11 as the hydrogen generators 10. The epitaxial growth devices 11 each have a space (reactor chamber 12) of an appropriate shape such as cylindrical or hemispherical and correspond to a device (furnace) that generates crystals on the surface of one to several silicon wafers 14 placed on a susceptor 13 inside. Here, the gases needed for crystal growth are introduced from a raw gas tank 15 through the gas inlet path 16 of each epitaxial growth device 11 into the reactor chamber 12. The gases after a certain reaction are discharged out of the reactor chamber 12 through a gas outlet path 17. The positions of the gas inlet and outlet paths 16 and 17 of each epitaxial growth device 11 are also allowed to be other than those shown in FIG. 1, and are configured in accordance with the structure of the reactor chamber 12 of the epitaxial growth device 11 and the production capacity of the device. For convenience, FIG. 1 shows three epitaxial growth devices 11. The number of epitaxial growth devices 11 may be one, ten, or more.

Types and reactions of typical gases supplied to the epitaxial growth device 11 are generally as follows:
Epitaxial Growth Film Formation

   SiCl₄+2H₂ => Si + 4HCl

   SiH2Cl2 => Si + 2HCl

   SiH₄ => Si + 2H₂

   SiHCl₃+H₂ => Si + 3HCl
Silicon Oxide Film Formation

   SiH₄+2O₂ => SiO₂ 2H₂O

   SiH₄+2H₂O => SiO₂ 4H₂

   SiCl₄+2NO+2H₂ => SiO₂+4HCl+N₂

   SiCl₄+2CO₂+2H₂ => SiO₂+4HCl+2CO

   SiH₂Cl₂+2N₂O => SiO₂+2HCl +2N₂
Silicon Nitride Film Formation

   3 SiH₂Cl₂+4NH₃ => Si₃N₄+6HCl+6H₂

   3SiH₄+4NH₃ => Si3N₄+12H₂
Polycrystalline Silicon Film Formation

   SiH₄ => Si+2H₂

As per the reaction equation described above, the generation of hydrogen is confirmed on the basis of the type of the source gas in conjunction with the supply of hydrogen to the epitaxial growth devices 11 and the reaction of the gas supplied to the epitaxial growth devices 11. The unreacted hydrogen and hydrogen produced by the reaction in the epitaxial growth devices 11 are collected as waste hydrogen and reused as fuel for power generation.

However, components other than hydrogen are present as components generated by the reaction in the epitaxial growth devices as per the above mentioned reaction equation. To address this, the purification unit 20 is provided downstream from the epitaxial growth devices 11. The purification unit 20 referred to as a scrubber, for example, collects waste hydrogen from the hydrogen generator and removes impurities other than hydrogen to prepare purified hydrogen. The purification unit 20 stores known adsorbents and water. Hydrogen is nearly insoluble in water. In contrast, hydrogen chloride is soluble in water. Accordingly, hydrogen chloride is reduced by bringing the gas discharged through the gas outlet path 17 into contact with water stored in the purification unit 20. In addition, a filter 21 may be provided downstream from the purification unit 20 to improve the degree of hydrogen purification. At the filter 21, components other than hydrogen, such as nitrogen and hydrogen chloride, are collected.

In the purification process to obtain purified hydrogen in the purification unit 20, the waste hydrogen is in contact with the water, and thus the purified hydrogen contains moisture. In general, the hydrogen as a fuel for fuel cells is considered to be almost 100% pure hydrogen. This needs devices and processes to, after purification, further remove moisture. In contrast, in the present embodiment, purified hydrogen is burned, and thus barriers due to purity, such as the moisture content of the hydrogen, may be ignored. This reduces the load of facilities and processing to increase the purity of hydrogen.

The storage unit 30 stores therein the purified hydrogen purified by the purification unit 20. The storage unit 30 corresponds to a gas tank for hydrogen. The purified hydrogen is stored in the storage unit 30 to supply hydrogen in sufficient quantity and pressure to the power generation unit 40. In the waste hydrogen power generation device 1A according to the first embodiment, the hydrogen discharged from the multiple epitaxial growth devices 11 is stored in one storage unit 30.

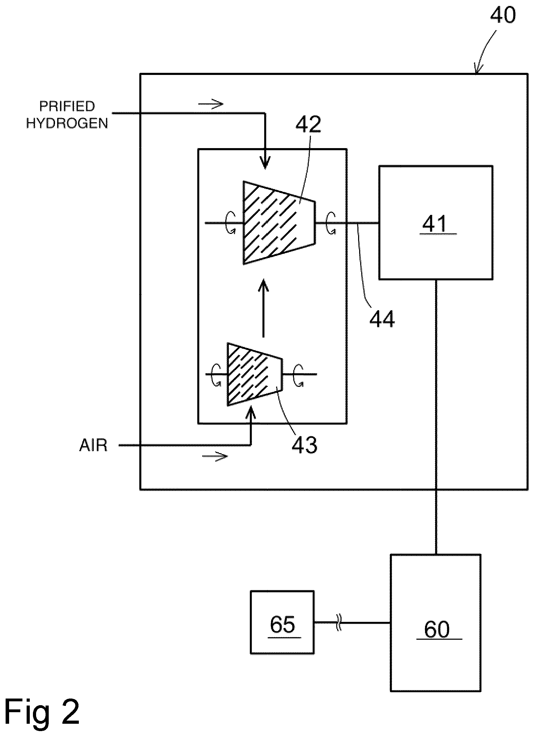

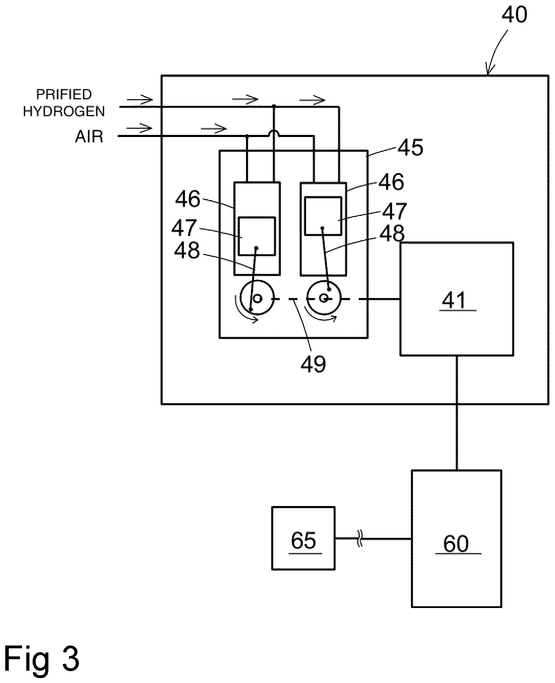

The power generation unit 40 is installed downstream from the storage unit 30 and uses the purified hydrogen as fuel to generate electricity. Mechanisms for combustion of purified hydrogen may include the use of a gas turbine shown in the schematic diagram in FIG. 2, and the use of an internal combustion engine shown in the schematic diagram in FIG. 3. The power generation unit 40 has a publicly known power generator 41. The specifications and number of power generators are appropriately selected depending on the size of the facility.

In the schematic diagram in FIG. 2, the power generation unit 40 includes a gas turbine unit 42 that combusts the purified hydrogen and oxygen in the atmosphere to generate rotational force. The rotational force generated in the gas turbine unit 42 moves the power generator 41 to generate electricity. In FIG. 2, the purified hydrogen is supplied as fuel to the gas turbine unit 42. In addition, air is supplied to a sub-turbine unit 43 and pressurized by the sub-turbine unit 43, and the pressurized air is supplied to the gas turbine unit 42. This increases the concentration of the oxygen to be higher than that at ambient pressure, which in turn increases the combustion efficiency of hydrogen, thereby increasing the rotational speed of the gas turbine unit 42, i.e., a turbine shaft 44. The turbine shaft 44 is connected to the power generator 41 from which electricity is generated.

The gas turbine unit 42 can accommodate various sizes from large to small. However, it is not suitable for sequential fluctuations from low to high speed ranges. In this case, purified hydrogen may be stored in a predetermined amount in the storage unit 30 and supplied to the gas turbine unit 42 at a predetermined pressure, allowing the gas turbine unit 42 to rotate at a relatively stable speed. Therefore, the form of power generation using the gas turbine unit 42 is a preferable example for manufacturing facilities in large semiconductor plants where the supply of purified hydrogen is relatively large.

In the schematic diagram in FIG. 3, the power generation unit 40 includes an internal combustion engine unit 45 that rotates by burning the purified hydrogen and oxygen in the atmosphere. The internal combustion engine unit 45 corresponds to a reciprocating engine with a structure common to known gasoline and diesel engines, for example, in which purified hydrogen is used as a fuel in place of gasoline and diesel oil. The internal combustion engine unit 45 shown in FIG. 3 includes pistons 47 each inserted through a corresponding cylinder 46. Purified hydrogen and air are supplied to the space sectioned by each cylinder 46 and the corresponding piston 47 in the internal combustion engine unit 45, and explosive combustion causes the piston 47 to move inside the cylinder 46. A rod 48 is connected to the corresponding piston 47, and the rod 48 is connected to a crankshaft 49. There, the linear motion of the piston 47 is converted into rotational motion of the crankshaft 49. The crankshaft 49 is connected to the power generator 41, and the rotational force generated on the crankshaft 49 causes the power generator 41 to generate electricity. In addition to the reciprocating engine using the purified hydrogen as fuel, rotary engines are also applicable.

The internal combustion engine unit 45 can flexibly adjust the speed of the crankshaft 49 when the supply of the purified hydrogen varies. Accordingly, it can flexibly respond to the supply-demand relationship of power generation. Primarily, the internal combustion engine unit 45 is preferably applied to a form in which a relatively small amount of purified hydrogen is used as fuel as shown in the waste hydrogen power generation device 1B according to a second embodiment (see FIG. 4) below.

The configuration of the power generation unit 40 disclosed in FIGS. 2 and 3 is an example of a power generation device or engine that uses purified hydrogen as fuel, and thus device configurations other than those described and illustrated are naturally included in the configuration of the power generation unit. Necessary configurations that are omitted from the description and illustration are also included appropriately.

The power storage unit 60 includes a secondary battery that stores the power generated by the power generation unit 40. Examples may include lead-acid batteries, sodium sulfur (NaS) batteries, and lithium-ion batteries. The amount and type of rechargeable batteries in the power storage unit 60 are selected in accordance with the power generation capacity and power usage. Since the power is direct current when stored and becomes alternating current in a power consumption unit 65, an inverter, for example, to convert from direct current to alternating current may be provided in the power storage unit 60. Once electricity is generated by the power generation unit 40 (power generator 41), it is charged to the rechargeable battery in the power storage unit 60 and discharged from the power storage unit 60. This allows the electricity to be stably supplied to, for example, the facilities in the semiconductor plant including the epitaxial growth devices 11 via the power storage unit 60.

FIG. 4 is a schematic diagram illustrating an overall configuration of a waste hydrogen power generation device 1B according to the second embodiment. In the waste hydrogen power generation device 1B, a power generation unit 80 is provided for each of the multiple hydrogen generators 10. The power generation unit 80 is configured by including a single enclosure 81. The purification unit 20, storage unit 30, and power generation unit 40 are housed in the enclosure 81 of the power generation unit 80. As shown in FIG. 4, the power storage unit 60 is also housed in the enclosure 81. In the waste hydrogen power generation device 1B according to the second embodiment, configurations common to the waste hydrogen power generation device 1A according to the first embodiment are described with the same reference numerals. In the power generation unit 80, the piping connects the components in the single enclosure 81, such as pressure gauges, check valves, and flow control valves in the appropriate form.

As understood from FIG. 4, one power generation unit 80 is allocated to a corresponding epitaxial growth device 11 of the hydrogen generator 10. Accordingly, power can be generated from each of the epitaxial growth devices 11. In the waste hydrogen power generation device 1B, purified hydrogen discarded and purified from one epitaxial growth device 11 does not mix with purified hydrogen from the other epitaxial growth devices 11. For example, when an abnormality occurs in a certain epitaxial growth device, only the power generation unit connected to the problematic epitaxial growth device can be shut down to minimize the drop in facility operating rate instead of shutting down the entire hydrogen power generation device.

In addition, since the power generation unit 80 itself has the ability to process waste hydrogen in an integrated manner, separate tanks, for example, need not be installed, and the power generation unit 80 itself is relatively easy to be installed and removed (carried out and carried in) within semiconductor manufacturing plants and facilities. It also has the advantage of reducing the load of installing piping for transporting and supplying waste hydrogen and purified hydrogen. Further, the number of power generation units 80 can be adjusted in accordance with the number of epitaxial growth devices 11 operating in the hydrogen generators 10, thereby facilitating the introduction of the power generation units 80 in accordance with the size of the semiconductor manufacturing plant.

The size of the power generation unit 80 (its enclosure 81) is designed in accordance with the size and capacity of the built-in purification unit 20, storage unit 30, and power generation unit 40 as well as the power storage unit 60. In addition, two epitaxial growth devices 11 may be connected to a single power generation unit 80 (i.e., its enclosure 81).

As described in the series of descriptions, the use of the waste hydrogen power generation device according to the embodiment allows hydrogen discarded in the manufacturing facilities for semiconductors, for example, to be reused for power generation with less load of purification, thereby assisting in supplying electricity to the facilities. Especially, since hydrogen is used as a fuel for combustion with air, the purity of hydrogen required for fuel cells is not needed, thereby reducing the load of facilities and processing needed for hydrogen purification.

Since the hydrogen generator corresponds to an epitaxial growth device, power can be generated from the hydrogen emitted in the semiconductor manufacturing process, thus assisting in electricity consumption.

Since the impurities are removed from the waste hydrogen through contact with the water, the device and process for preparing the purified hydrogen from the waste hydrogen are simplified.

The power generation unit includes a gas turbine unit that rotates by combusting the purified hydrogen and oxygen in the atmosphere, and the rotational force generated in the gas turbine unit moves the power generator, enabling stable power generation in large-scale facilities.

The power generation unit includes an internal combustion engine unit that combusts purified hydrogen and oxygen in the atmosphere to obtain rotational force, and the rotational force generated in the internal combustion engine unit moves the power generator, enabling flexible power generation in small facilities.

A power storage unit that stores the power generated in the power generation unit allows power to be stably supplied to facilities and equipment, for example.

Since the purification, storage, and power generation units are housed in a single enclosure, they can be easily installed and removed as a power generation unit in a manufacturing plant or facility, thereby reducing the load of installing piping to transfer and supply waste hydrogen and purified hydrogen.

In addition, the epitaxial growth device is the main object as the hydrogen generator, and simultaneously, the power generation unit can be introduced into other plants where hydrogen is discharged from the manufacturing process, such as iron manufacturing facilities, thereby contributing to the effective utilization of waste hydrogen.

### Description of Reference Numerals

1A, 1B: Waste Hydrogen Power Generation Device
10: Hydrogen Generator
11: Epitaxial Growth Device
12: Reactor Chamber
13: Susceptor
14: Wafer
15: Raw Gas Tank
16: Gas Inlet Path
17: Gas Outlet Path
20: Purification Unit
21: Filter
30: Storage Unit
40: Power Generation Unit
41: Power Generator
42: Gas Turbine Unit
44: Turbine Shaft
45: Internal Combustion Engine Unit
49: Crankshaft
60: Power Storage Unit
65: Power Consumption Unit
70: Piping
71, 72, 73: Pressure Gauge
74: Check Valve
75: Flow Control Valve
80: Power Generation Unit
81: Enclosure

## Claims

1. A waste hydrogen power generation device (1A; 1B), comprising:
a hydrogen generator (10);
a purification unit (20) that collects waste hydrogen discarded from the hydrogen generator (10) and removes impurities other than hydrogen to prepare purified hydrogen;
a storage unit (30) that stores the purified hydrogen; and
a power generation unit (40) that operates a power generator (41) by combusting the purified hydrogen supplied from the storage unit (30) and oxygen in an atmosphere.

2. The waste hydrogen power generation device (1A; 1B) according to claim 1, wherein the hydrogen generator (10) is an epitaxial growth device (11).

3. The waste hydrogen power generation device (1A; 1B) according to claim 1, wherein the impurities are removed from the waste hydrogen through contact with water in the purification unit (20).

4. The waste hydrogen power generation device (1A; 1B) according to claim 1, wherein the power generation unit (40) includes a gas turbine unit (42) that rotates by combustion of the purified hydrogen and oxygen in an atmosphere, and rotational force generated in the gas turbine unit (42) moves the power generator (41).

5. The waste hydrogen power generation device (1A; 1B) according to claim 1, wherein the power generation unit (40) includes an internal combustion engine unit (45) that combusts the purified hydrogen and oxygen in an atmosphere to obtain rotational force, and the rotational force generated in the internal combustion engine unit (45) moves the power generator (41).

6. The waste hydrogen power generation device (1A; 1B) according to claim 1, further comprising a power storage unit (60) that stores power generated in the power generation unit (40).

7. The waste hydrogen power generation device (1A; 1B) according to claim 1, wherein the purification unit (20), the storage unit (30), and the power generation unit (40) are housed in a single enclosure (81).
